(19) 

Europäisches
Patentamt
European
Patent Office
Office européen
des brevets

(11) **EP 4 764 557 A1**

(12) **EUROPEAN PATENT APPLICATION**
published in accordance with Art. 153(4) EPC

(43) Date of publication:
**24.06.2026  Bulletin 2026/26**

(21) Application number: **24889097.2**

(22) Date of filing: **05.11.2024**

(51) International Patent Classification (IPC):
*G01R 31/396* (2019.01)      *G01R 31/382* (2019.01)
*G01R 31/392* (2019.01)      *G01R 19/00* (2006.01)
*G01R 31/371* (2019.01)      *G01R 31/36* (2020.01)

(52) Cooperative Patent Classification (CPC):
**G01R 19/00; G01R 31/36; G01R 31/371;**
**G01R 31/382; G01R 31/392; G01R 31/396;**
**Y02E 60/10**

(86) International application number:
**PCT/KR2024/017330**

(87) International publication number:
**WO 2025/100910 (15.05.2025 Gazette 2025/20)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority:  **10.11.2023   KR 20230155641**

(71) Applicant: **LG Energy Solution, Ltd.**
**Seoul 07335 (KR)**

(72) Inventors:
• **EOM, Jee Yong**
  **Daejeon 34122 (KR)**
• **KIM, Gyeong Mo**
  **Daejeon 34122 (KR)**
• **KIM, Young Jae**
  **Daejeon 34122 (KR)**

(74) Representative: **Goddar, Heinz J.**
**Boehmert & Boehmert**
**Anwaltspartnerschaft mbB**
**Pettenkoferstrasse 22**
**80336 München (DE)**

(54) **BATTERY MANAGEMENT DEVICE AND BATTERY MANAGEMENT METHOD**

(57)   A battery management apparatus disclosed herein includes a communication unit configured to receive battery data of a battery cell and a control unit configured to generate discharging capacity change rate data based on the battery data, smooth the voltage data and the discharging capacity change rate data to obtain voltage smoothing data and discharging capacity smoothing data, and determine that the battery cell is defective based on that the voltage smoothing data and the discharging capacity smoothing data satisfy a defect determination condition.

FIG.3

# Description

## Technical Field

CROSS-REFERENCE TO RELATED APPLICATION

This application claims priority to and the benefit of Korean Patent Application No. 10-2023-0155641 filed in the Korean Intellectual Property Office on November 10, 2023, the entire content of which is incorporated herein by reference.

TECHNICAL FIELD

Embodiments disclosed herein relate to a battery management apparatus and a battery management method.

## Background Art

Recently, research and development of secondary batteries have been actively performed. Herein, the secondary batteries, which are chargeable/-dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices. In addition, the lithium-ion battery is attracting attention as a next-generation energy storage medium as a usage range thereof is expanded to a power source of electric vehicles.

When there is a battery cell having an assembly defect in a battery, heat emission or ignition may occur in a charging/discharging process, causing a risk of safety, such that research has been conducted on an algorithm for detecting the assembly-defective battery cell. Generally, to detect the assembly-defective battery cell, raw data is used without smoothing the raw data, such that a profile shows a sporadic form, making it difficult to detect the defective battery cell.

## Disclosure

## Technical Problem

According to an embodiment disclosed herein, there are provided a battery management apparatus and method in which exponential smoothing is applied to raw battery data to detect a defective battery cell.

Technical problems of the embodiments disclosed herein are not limited to the above-described technical problems, and other unmentioned technical problems would be clearly understood by one of ordinary skill in the art from the following description.

## Technical Solution

A battery management apparatus according to an embodiment includes a communication unit configured to receive battery data including voltage data of a battery cell and a control unit configured to generate discharging capacity change rate data based on the battery data, smooth the voltage data and the discharging capacity change rate data to obtain voltage smoothing data and discharging capacity smoothing data, and determine that the battery cell is defective based on that the voltage smoothing data and the discharging capacity smoothing data satisfy a defect determination condition.

The controller may be further configured to perform exponential smoothing on the voltage data and the discharging capacity change rate data based on a smoothing coefficient applied to exponential smoothing.

The controller may be further configured to obtain a predicted value by performing weighted averaging on a past predicted value and a past observed value to exponentially smooth the voltage data and the discharging capacity change rate data.

The controller may be further configured to determine that the battery cell is defective, based on that the voltage smoothing data and the discharging capacity smoothing data satisfy the defect determination condition at the same time in a preset determination period.

The controller may be further configured to determine that the voltage smoothing data and the discharging capacity smoothing data satisfy the defect determination condition, based on that the voltage smoothing data is less than a voltage average of a plurality of battery cells for a preset unit time and the discharging capacity smoothing data is greater than a discharging capacity change rate of the plurality of battery cells for the unit time.

The controller may be further configured to determine that the voltage smoothing data and the discharging capacity smoothing data satisfy the defect determination condition, based on that the number of times the voltage smoothing data is less than the voltage average and the number of times the discharging capacity smoothing data exceeds the discharging capacity change rate are greater than or equal to a preset reference number of times in the determination period.

The controller may be further configured to transmit information about the battery cell determined as being defective to an external device through the communication unit.

A battery management method according to an embodiment includes receiving battery data including voltage data of a battery cell, generating discharging capacity change rate data based on the battery data, smoothing the voltage data and the discharging capacity change rate data to obtain voltage smoothing data and discharging capacity smoothing data, and determining that the battery cell is defective, based on that the voltage smoothing data and the discharging capacity smoothing data satisfy a defect determination condition.

The smoothing of the voltage data and the discharging capacity change rate data may include performing exponential smoothing on the voltage data and the discharging capacity change rate data based on a smoothing coefficient applied to exponential smoothing.

The smoothing of the voltage data and the discharging capacity change rate data may include obtaining a predicted value by performing weighted averaging on a past predicted value and a past observed value to exponentially smooth the voltage data and the discharging capacity change rate data.

The determining that the battery cell is defective may include determining that the battery cell is defective, based on that the voltage smoothing data and the discharging capacity smoothing data satisfy the defect determination condition at the same time in a preset determination period.

The battery management method according to an embodiment may further include determining that the voltage smoothing data and the discharging capacity smoothing data satisfy the defect determination condition, based on that the voltage smoothing data is less than a voltage average of a plurality of battery cells for a preset unit time and the discharging capacity smoothing data is greater than a discharging capacity change rate of the plurality of battery cells for the unit time.

The battery management method according to an embodiment may further include determining that the voltage smoothing data and the discharging capacity smoothing data satisfy the defect determination condition, based on that the number of times the voltage smoothing data is less than the voltage average and the number of times the discharging capacity smoothing data exceeds the discharging capacity change rate are greater than or equal to a preset reference number of times in the determination period.

The battery management method according to an embodiment may further include transmitting information about the battery cell determined as being defective to an external device through a communication unit.

## Advantageous Effects

With a battery management apparatus according to an embodiment, the efficiency of detection of an assembly-defective battery cell may be improved by using smoothing data and a fire risk in use of a battery may be minimized by early detecting the assembly-defective battery cell.

## Description of Drawings

FIG. 1 is a block diagram showing a configuration of a general battery system including a battery management apparatus according to an embodiment.

FIG. 2 is a block diagram showing a configuration of a battery management apparatus according to an embodiment.

FIG. 3 schematically shows a flow for a battery management apparatus according to an embodiment to determine whether a battery is defective.

FIG. 4A shows raw data of a discharging capacity change rate used in a battery management apparatus according to an embodiment.

FIG. 4B shows raw data of a voltage used in a battery management apparatus according to an embodiment.

FIG. 5A shows smoothing data of a discharging capacity change rate used in a battery management apparatus according to an embodiment.

FIG. 5B shows smoothing data of a voltage used in a battery management apparatus according to an embodiment.

FIG. 6 shows a defect determination condition used in a battery management apparatus according to an embodiment.

FIG. 7 is a control flowchart of a battery management method according to an embodiment.

## Mode for Invention

Hereinafter, various embodiments disclosed herein will be described in detail with reference to the accompanying drawings. In this document, identical reference numerals will be used for identical components in the drawings, and the identical components will not be redundantly described.

For various embodiments disclosed herein, specific structural or functional descriptions are only exemplified for the purpose of describing the embodiments, and various embodiments disclosed herein may be implemented in various forms, and should not be construed as being limited to the embodiments described herein.

As used in various embodiments, the terms "1st, "2nd", "first", "second", or the like may modify various components regardless of importance, and do not limit the components. For example, a first component may be named as a second component without departing from the right scope of an embodiment disclosed herein, and similarly, the second component may be named as the first component.

Terms used herein are used for only describing a specific exemplary embodiment and may not have an intention to limit the scope of other exemplary embodiments. It is to be understood that the singular forms include plural references unless the context clearly dictates otherwise.

All terms including technical or scientific terms used herein have the same meaning as commonly understood by those of ordinary skill in the art to which the embodiments disclosed herein belong. It will be further understood that terms, such as those defined in commonly used dictionaries, should be interpreted as having a meaning that is identical to or similar with their meaning in the context of the relevant art and will not be interpreted in an idealized or overly formal sense unless expressly so defined herein. In some cases, the terms defined herein may be interpreted to exclude embodiments disclosed herein.

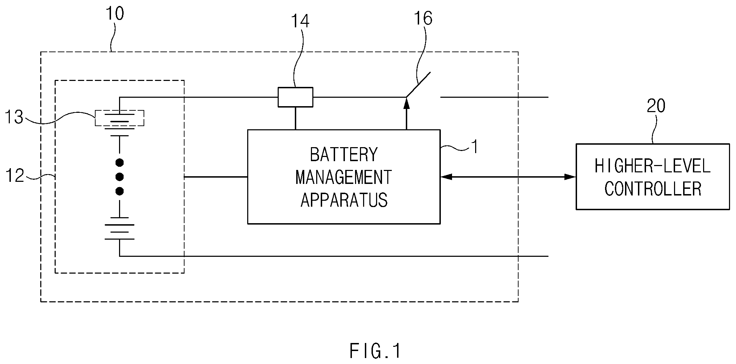

FIG. 1 is a block diagram showing a configuration of a general battery system including a battery management apparatus according to various embodiments.

Specifically, FIG. 1 schematically shows a battery system 10 and a higher-level controller 20 included in a higher-level system according to an embodiment disclosed herein.

As shown in FIG. 1, the battery system 10 may include a plurality of battery modules 12, a sensor unit 14, a switching unit 16, and a battery management apparatus 1. The battery system 10 may include the battery module 12, the sensor unit 14, the switching unit 16, and the battery management apparatus 1 provided in plural.

The plurality of battery modules 12 may include at least one chargeable/dischargeable battery cells 13. The battery cell 13 may include a positive electrode, a positive electrode material, a negative electrode, a negative electrode material, a separator, polymer, and a case. In this case, the plurality of battery modules 12 may be connected in series or in parallel.

The sensor unit 14 may include a voltage sensor 2, a current sensor 3, and a temperature sensor (not shown).

The voltage sensor 2 may be connected in parallel with the battery and configured to detect a battery voltage across opposite ends of the battery and generate a voltage signal indicating the detected battery voltage.

The current sensor 3 may detect a current used in a process of determining a state of charge (SOC) of the battery cell 13.

The current sensor 3 may include any component for generating a signal corresponding to a magnitude of a charging current, and may be installed on a charging/discharging path in which the charging/discharging current flows in a battery.

The current sensor 3 may measure a battery current flowing in the battery, i.e., a charging current and a discharging current, and transmit a measurement result to the battery management apparatus 1. According to an embodiment, the current sensor 3 may measure the battery current at predetermined intervals and transmit a measurement result to the battery management apparatus 1, in a charging cycle for charging the battery with power of an external device or a discharging cycle for discharging the battery.

The temperature sensor may be configured to measure a battery temperature and generate a temperature signal indicating the measured battery temperature. The temperature sensor may be disposed in a case to measure a temperature close to an actual temperature of the battery. For example, the temperature sensor may be attached to a surface of at least one battery cell included in a cell group and detect the surface temperature of the battery cell as the battery temperature.

The temperature sensor may be configured to measure an external temperature that is a temperature at a predetermined position spaced apart from the battery and generate the temperature signal indicating the measured external temperature. The temperature sensor may be arranged at a predetermined position outside the case in which heat exchange is made between the battery and the atmosphere. According to an embodiment, the temperature sensor may be implemented in combination of one or two or more of known temperature detection elements such as a thermocouple, a thermistor, a bimetal, etc. The current sensor may detect current flowing in the battery system 10. In this case, a detection signal may be transmitted to the battery management apparatus 1.

While the sensor unit 14 is connected between a positive electrode of the battery cell 13 and the switching unit 16 in FIG. 1, a connection relationship between components shown in FIG. 1 may be an example and is not limited thereto.

The switching unit 16 may be serially connected to a positive (+) terminal side or a negative (-) terminal side of the battery module 12 to control a charging/-discharging current flow of the battery module 12. For example, for the switching unit 16, at least one relay, a magnetic contactor, etc., may be used, depending on the specification of the battery system 10.

The battery management apparatus 1 may perform control and management to prevent over-charging and over-discharging by monitoring voltage, current, temperature, etc., of the battery system 10, and may include, for example, a battery management system (BMS).

The battery management apparatus 1, which is an interface for receiving measurement values of the above-described various parameter values, may include a plurality of terminals and a circuit, etc., connected thereto to process input values. Further, the battery management apparatus 1 may control the switching unit 16, for example, on/off of a relay, a contactor, etc., and may be connected to the battery module 12 to monitor a state of each battery module 12.

The battery management apparatus 1 may receive temperature data, voltage data, and current data from the sensor unit 14 to obtain battery state information and diagnose a state of the battery.

The higher-level controller 20 may transmit a control signal for controlling the battery module 12 to the battery management apparatus 1. Thus, the battery management apparatus 1 may be controlled in terms of an operation thereof based on the control signal applied from the higher-level controller 20. Also, the battery module 12 may be a component included in an energy storage system (ESS). In this case, the higher-level controller 20 may be a control unit (BBMS) of a battery bank including the plurality of battery systems 10 or an ESS control unit for controlling the entire ESS including a plurality of banks. However, the battery system 10 is not limited to such a purpose.

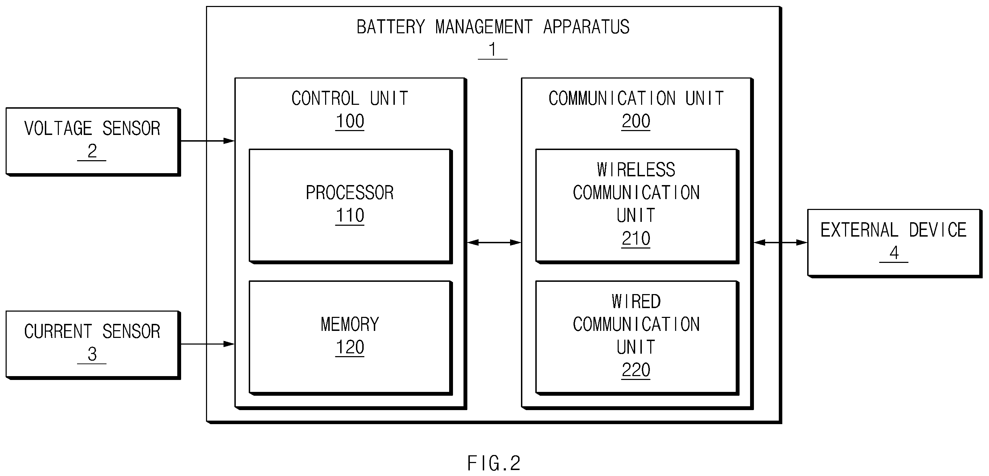

FIG. 2 is a block diagram showing a configuration of a battery management apparatus according to an embodiment.

Referring to FIG. 2, the battery management apparatus 1 according to an embodiment may include a control unit 100 including at least one processor 110 and a memory 120 and a communication unit 200, and may diagnose a battery by communicating with an external device 4 through the communication unit 200.

According to an embodiment, the external device 4 communicating with the battery management apparatus 1 may include a user terminal that transmits a diagnosis result of the battery management apparatus 1.

Specifically, when the external device 4 is a user terminal, the control unit 100 of the battery management apparatus 1 may transmit a diagnosis result of the battery to the user terminal to enable a user to check the diagnosis result. In this case, the user terminal may include, but not limited to, a personal computer (PC), a terminal, a portable telephone, a smart phone, a handheld device, a wearable device, etc.

When the external device 4 is a server device, the server device may be implemented with various computing devices such as workstations, clouds, data drives, data stations, etc. The server device may be implemented as one or more server devices physically or logically separated based on a function, a detailed configuration thereof, data, etc., and data may be transmitted and received through communication between server devices and the transmitted and received data may be processed.

The battery management apparatus 1 according to an embodiment may mean any electronic device including the processor 110 and the memory 120, and may be mounted on a vehicle to operate. Hereinbelow, each component of the battery management apparatus 1 may be described in detail.

The communication unit 200 may include a wireless communication unit 210 and a wired communication unit 220 to communicate with the external device 4. The communication unit 200 may transmit and receive a program for feature calculation, class classification, and lifetime estimation for a battery cell or various data, etc., to and from a separately provided external server.

The wireless communication unit 210 may include at least one of a short-range communication module or a long-range communication module.

The short-range communication module may communicate with the external device 4 adjacent to the battery management apparatus 1 by using a short-range communication method. Herein, the short-range communication module may use one communication method among Bluetooth, Bluetooth low energy (BLE), infrared data association (IrDA), Zigbee, WiFi, WiFi Direct, ultra-wideband (UWB), or near field communication (NFC).

The long-range wireless communication module may include a communication module performing various types of long-range communication, and may include a mobile communication module. The mobile communication unit may transmit and receive a radio signal to and from at least one of a base station, an external terminal, or the external device 4 over a mobile communication network. The long-range communication module may communicate with the external device 4 or other electronic devices, etc., through a nearby access point (AP). The AP may connect a local area network (LAN) to which the battery management apparatus 1 is connected to a wide area network (WAN) to which the communication server is connected. Thus, the battery management apparatus 1 may be connected to the communication server through the external device 4 and the WAN to communicate with each other.

The wired communication unit 220 may access the wired communication network and communicate with the external device 4 through the wired communication network. For example, the wired communication unit 220 may access the wired communication network through Ethernet (IEEE 802.3, technical standards), access the wired communication network through CAN communication, and transmit and receive data to and from the external devices 4 through the wired communication network.

The battery management apparatus 1 according to an embodiment may include an input/output interface (not shown). An interface may be provided to allow data to be transmitted and received by connecting an input device (not shown) such as a keyboard, a mouse, a touch panel, etc., an output device such as a display (not shown), etc., and the processor 110.

The memory 120 may store various information required for driving of the battery management apparatus 1. Specifically, the memory 120 may store an operating system and a program required for driving of the battery management apparatus 1 or store data required for driving of the battery management apparatus 1.

Specifically, the memory 120 may store various programs regarding feature calculation, class classification, and lifetime estimation of the battery cell. Moreover, the memory 120 may store various data such as a voltage, a current, feature data, etc., of each battery cell.

The memory 120 may also store a defect determination condition of the battery cell 13, used by the processor 110.

The memory 120 may include a volatile memory 120 such as a static random access memory (S-RAM) and a dynamic random access memory (D-RAM) to temporarily memorize data. The memory 120 may also include a non-volatile memory 120 such as read only memory (ROM), erasable programmable read only memory (EPROM), and electrically erasable programmable read only memory (EEPROM), to store data for a long time.

The processor 110 may control in overall the battery management apparatus 1 by outputting a control signal. The processor 110 may include one CPU or graphics processing unit (GPU) or a plurality of CPUs or GPUs. In this case, the processor 110 may be implemented as an array of multiple logic gates, or may be implemented as a combination of the general-purpose microprocessor 110 and the memory 120 storing a program executable on the microprocessor 110.

The memory 120 and the processor 110 may be included in the control unit 100 that controls the above-described components to determine whether a defect occurs in a battery cell.

The control unit 100 may generate discharging capacity change rate data based on battery data and smooth voltage data and the discharging capacity change rate data to obtain voltage smoothing data and discharging capacity smoothing data. The control unit 100 may perform exponential smoothing on the voltage data and the discharging capacity change rate data based on a smoothing coefficient applied to exponential smoothing.

Specifically, the control unit 100 may obtain a predicted value by performing weighted averaging on a past predicted value and a past observed value to exponentially smooth the voltage data and the discharging capacity change rate data.

The control unit 100 may determine a battery cell as being defective based on that the voltage smoothing data and the discharging capacity smoothing data satisfy a defect determination condition, and transmit information of the battery cell determined as being defective to the external device 4 through the communication unit 200.

The control unit 100 may determine the battery cell as being defective, based on that the voltage smoothing data and the discharging capacity smoothing data satisfy the defect determination condition at the same time in a preset determination period. Thus, the control unit 100 may determine whether the battery cell is defective according to two conditions, thereby reducing misdiagnosis and providing accurate diagnosis.

In relation to the defect determination condition of the battery cell, the control unit 100 may determine that the defect determination condition is satisfied, when the voltage smoothing data is less than a voltage average of a plurality of battery cells for a preset unit time and the discharging capacity smoothing data is greater than a discharging capacity change rate of the plurality of battery cells for the unit time.

The control unit 100 may determine that the defect determination condition is satisfied based on that the number of times the voltage smoothing data is less than the voltage average and the number of times the discharging capacity smoothing data exceeds the discharging capacity change rate are greater than or equal to a preset reference number of times in a determination period.

In this way, the battery management apparatus 1 according to an embodiment may smooth the raw battery data and diagnose whether a defect occurs in a battery cell by using both the voltage smoothing data and the discharging capacity smoothing data, thereby significantly improving the reliability of diagnosis.

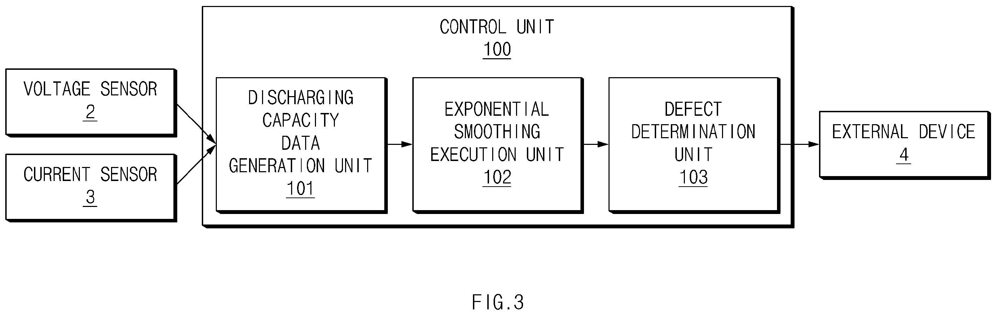

FIG. 3 schematically shows a flow for a battery management apparatus according to an embodiment to determine whether a battery is defective. Components 101 to 103 in FIG. 3 may be implemented in the form of a software block, and may be stored in the memory 120 and executed by the processor 110.

The control unit 100 may receive battery data of a battery cell from the sensor unit, specifically, voltage data from the voltage sensor 2 and current data from the current sensor 3.

A discharging capacity data generation unit 101 of the control unit 100 may generate discharging capacity data through integration of current-voltage data. That is, the control unit 100 may integrate the current-voltage data to obtain an area of a discharging curve indicating a voltage with respect to time under a specific current, and generate discharging capacity data with the area of the discharging curve.

The control unit 100 may generate discharging capacity change rate data as a change rate of the discharging capacity data, and may generate the discharging capacity change rate data that is a difference from a previous data point by using a discharging capacity data point according to each time interval.

For example, for two consecutive data points ($t_i$, $C_i$) and ($t_{i+1}$, $C_{i+1}$), a discharging capacity change rate R may be calculated by an equation provided below.

$$【Equation 1】$$

$$R = (C_{i+1} - C_i)/(t_{i+1} - t_i)$$

Herein, $C_i$ and $C_{i+1}$ may mean discharging capacities for two consecutive time intervals, and $t_1$ and $t_{i+1}$ may mean measurement times of $C_i$ and $C_{i+1}$.

Thereafter, an exponential smoothing execution unit 102 of the control unit 100 may perform exponential smoothing on the received voltage data and the discharging capacity change rate data in which exponential smoothing may smooth time-series battery data to remove a trend or seasonality and alleviate noise.

The control unit 100 may smooth the voltage data and the discharging capacity data based on simple exponential smoothing or dual exponential smoothing, but there is no limitation in a method as long as the method is capable of smoothing data.

A defect determination unit 103 of the control unit 100 may determine that a battery cell is defective when the smoothed voltage smoothing data and discharging capacity smoothing data satisfy a specific condition.

That is, the control unit 100 may determine that the battery cell is defective when both the voltage smoothing data and the discharging capacity smoothing data respectively satisfy the defect determination conditions such that both the two conditions are satisfied. In this case, the control unit 100 may determine that the battery cell is normal to prevent misdiagnosis when one of the voltage smoothing data and the discharging capacity smoothing data satisfies the defect determination condition.

Thereafter, the control unit 100 may transmit information of the battery cell determined as being defective or normal to the external device 4, and a battery user or manager may remotely determine whether the battery cell is defective through the external device 4.

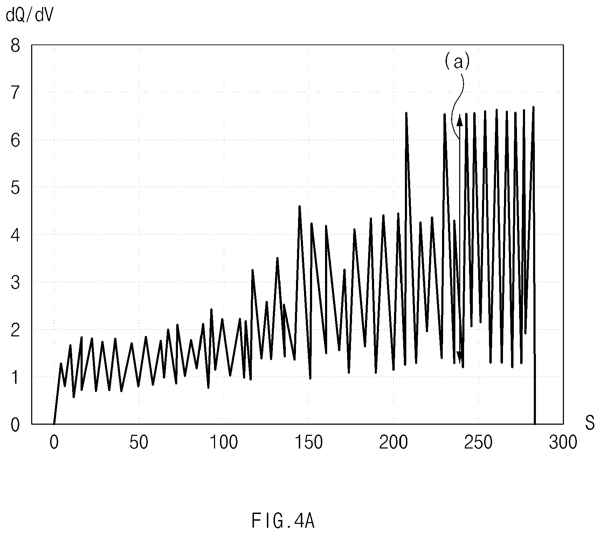

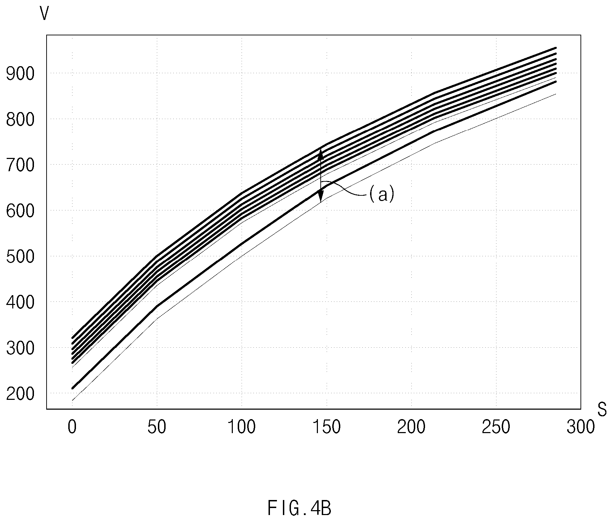

FIG. 4A shows raw data of a discharging capacity change rate used in a battery management apparatus according to an embodiment, and FIG. 4B shows raw data of a voltage used in a battery management apparatus according to an embodiment.

Referring to FIG. 4A, the control unit 100 may obtain the discharging capacity change rate data based on the battery data in which the discharging capacity change rate data may be shown as a discharging capacity change rate graph as shown in FIG. 4A.

Referring to FIG. 4B, the control unit 100 may obtain voltage data included in battery data in which the voltage data may be shown as a voltage graph as shown in FIG. 4B.

As shown in FIGS. 4A and 4B, raw data without exponential smoothing has a profile in a sporadic form, such that when it is determined whether the battery is defective by using raw data as in the conventional art, then it may be difficult to select specifications for selecting defects.

Thus, when it is determined whether the battery is defective by using the raw data as in the conventional art, a defect detection power may be reduced, failing in detecting a battery defect and thus causing battery ignition and accident.

Specifically, in FIG. 4A, the raw data is not smoothed, such that a fluctuation range (a) of the discharging capacity change rate graph is close to 6. Also in FIG. 4B, due to the raw data, the fluctuation range (a) of the voltage graph is close to 150 at 150 seconds.

As such, the raw data has a wider fluctuation range and more noise than the smoothing data, thus distorting actual data and reducing the accuracy of analysis for detecting a battery defect.

On the other hand, the battery management apparatus 1 according to an embodiment may reduce fluctuation of battery data through smoothing and minimize instability of the battery data. In this way, misdetection of battery performance degradation may be prevented, and an error in battery defect diagnosis may be minimized.

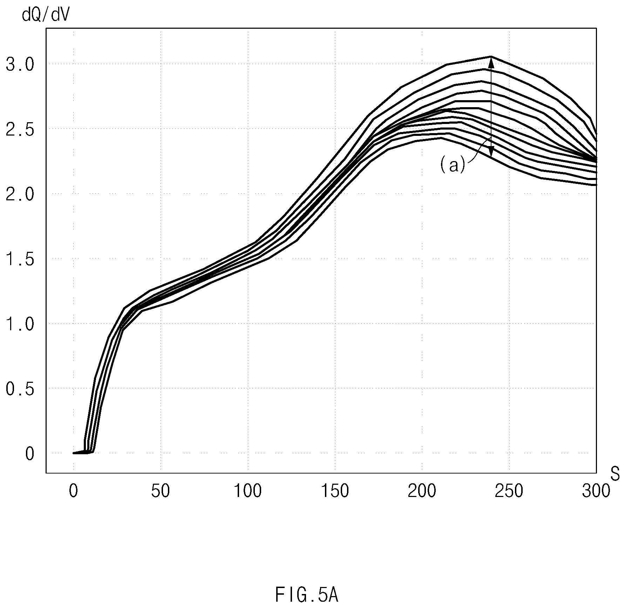

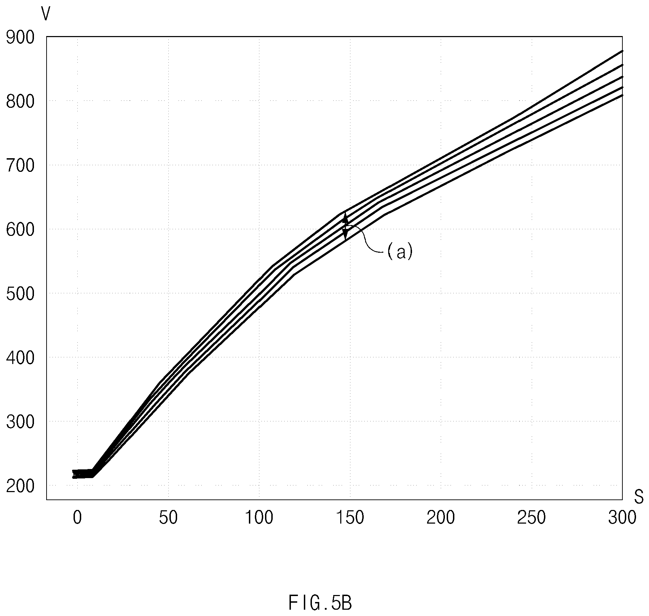

FIG. 5A shows smoothing data of a discharging capacity change rate used in a battery management apparatus according to an embodiment, and FIG. 5B shows smoothing data of a voltage used in a battery management apparatus according to an embodiment.

Referring to FIG. 5A, the control unit 100 may obtain the discharging capacity smoothing data by performing exponential smoothing on the discharging capacity change rate data, in which the discharging capacity smoothing data may be shown as a discharging capacity change rate graph as shown in FIG. 5A.

Referring to FIG. 5B, the control unit 100 may obtain voltage smoothing data by performing exponential smoothing on voltage data in which the voltage smoothing data may be shown as a voltage graph as shown in FIG. 5B.

As in FIGS. 5A and 5B, the smoothed smoothing data has a profile in a gentle form, such that it is easy to select the specifications for selecting a battery defect and a detection power may be improved.

Thus, like the battery management apparatus 1 according to an embodiment, when it is determined whether the battery is defective by using the smoothing data, a defect detection power may be improved and thus battery ignition and accident related thereto may be prevented.

Specifically, in FIG. 5A, the data is the smoothed discharging capacity smoothing data, and thus the fluctuation range (a) of the discharging capacity change rate graph is 0.8, such that it may be seen that the fluctuation range is reduced when compared to the raw data. Also in FIG. 5B, due to the smoothed voltage smoothing data, it may be seen that the fluctuation range (a) of the voltage graph is reduced to 40 at 150 seconds.

In this way, the smoothing data has a narrower fluctuation range than the raw data and has a change that is easy to observe over time and has less noise, thereby increasing the accuracy of interpretation for battery defect detection.

Hereinbelow, a defect determination condition for determining whether a battery cell is defective based on the smoothed data by the battery management apparatus 1 according to an embodiment will be described.

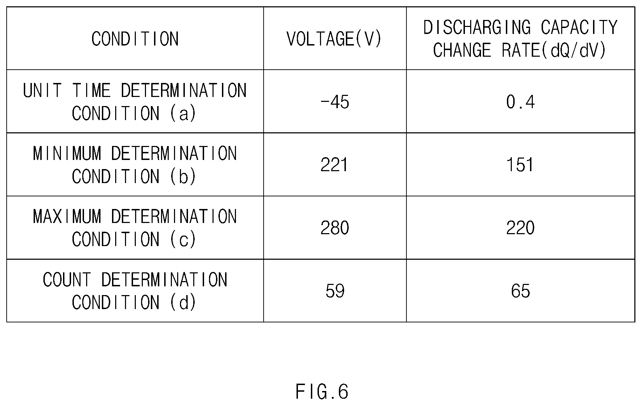

FIG. 6 shows a defect determination condition used in a battery management apparatus according to an embodiment.

Referring to FIG. 6, the control unit 100 may determine whether the voltage smoothing data and the discharging capacity smoothing data satisfy at least one of defect determination conditions: (a) a unit time determination condition; (b) a minimum determination condition; (c) a maximum determination condition; and (d) a count determination condition.

Moreover, the control unit 100 may determine whether each of the voltage smoothing data and the discharging capacity smoothing data satisfies any one of the defect determination conditions, and the control unit 100 may determine that the battery cell is defective, when each of the voltage smoothing data and the discharging capacity smoothing data satisfies any one of the defect determination conditions.

That is, when the discharging capacity smoothing data satisfies none of the defect determination conditions although the voltage smoothing data satisfies at least one of the defect determination conditions, the control unit 100 may determine that a battery defect does not occur, and when the voltage smoothing data satisfies none of the defect determination conditions although the discharging capacity smoothing data satisfies at least one of the defect determination conditions, the control unit 100 may determine that the battery defect does not occur.

In this way, the battery management apparatus 1 according to an embodiment may strictly and accurately determine whether the battery is defective.

Specifically, the control unit 100 may set the whole determination period, for example, a determination period from 0 to 300 seconds.

Thereafter, for (a) the unit time determination condition related to a voltage, the control unit 100 may determine that the battery satisfies the defect determination condition when an average voltage of battery cells included in one battery tray is less than - 45 mV in the determination period.

For (a) the unit time determination condition related to a discharging capacity change rate, the control unit 100 may determine that the battery satisfies the defect determination condition when an average discharging capacity change rate of the battery cells included in one battery tray is at least 0.4 in the determination period.

For (b) the minimum determination condition and (c) the maximum determination condition related to a voltage, the control unit 100 may determine whether a defect occurs by performing defect determination for the voltage smoothing data in a range from a minimum of 221 seconds to a maximum of 280 seconds.

For (b) the minimum determination condition and (c) the maximum determination condition related to a discharging capacity change rate, the control unit 100 may determine whether a defect occurs by performing defect determination for the voltage smoothing data in a range from a minimum of 221 seconds to a maximum of 280 seconds.

That is, the battery management apparatus 1 according to an embodiment may set an optimal determination range for determining whether the battery is defective by limiting (b) the minimum determination condition and (c) the maximum determination condition that may be set by experiment.

For (d) the count determination condition related to a voltage, the control unit 100 may count the number of times the voltage smoothing data is determined as whether the defect occurs in the determination period and the counted number is at least 59.

For (d) the count determination condition related to a discharging capacity change rate, the control unit 100 may count the number of times the discharging capacity smoothing data is determined as whether the defect occurs in the determination period and the counted number is at least 65.

That is, the control unit 100 may determine that the battery is defective when the voltage smoothing data satisfies at least one of (a) the unit time determination condition, (b) the minimum determination condition, (c) the maximum determination condition, and (d) the count determination condition and the discharging capacity smoothing data satisfies at least one of (a) the unit time determination condition, (b) the minimum determination condition, (c) the maximum determination condition, and (d) the count determination condition at the same time.

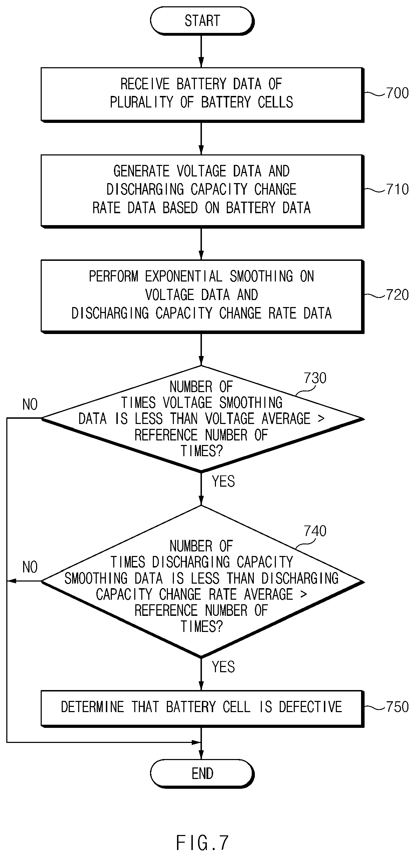

FIG. 7 is a control flowchart of a battery management method according to an embodiment.

Referring to FIG. 7, the control unit 100 may receive battery data of a plurality of battery cells in operation 700. The battery data received by the control unit 100 may be for each battery cell or each battery module.

The control unit 100 may generate voltage data based on the battery data and generate discharging capacity change rate data, in operation 710. The voltage data may mean data obtained by extracting a voltage value from the battery data and arranging the voltage value in time series, and the discharging capacity change rate data may mean change rate data of a discharging capacity calculated based on the current data and the voltage data.

The control unit 100 may perform exponential smoothing by applying an exponential smoothing logic to the voltage data and the discharging capacity change rate raw data, in operation 720. Thus, the control unit 100 may improve a defect battery detection power by smoothing the raw data.

Thereafter, the control unit 100 may determine whether the number of times of defect determination in which the voltage smoothing data is less than the voltage average of the plurality of battery cells exceeds a reference number of times, in operation 730.

When it is determined that the number of times of defect determination in which the voltage smoothing data is less than the voltage average of the plurality of battery cells exceeds the reference number of times (yes in operation 730), the control unit 100 may determine whether the number of times of defect determination in which the discharging capacity smoothing data is less than a discharging capacity change rate average exceeds a reference number of times, in operation 740.

When it is determined that the number of times of defect determination in which the discharging capacity smoothing data is less than the discharging capacity change rate average exceeds the reference number of times (yes in operation 740), the control unit 100 may determine that the battery cell is defective, in operation 750.

At this time, an order of performing defect determination for the voltage smoothing data and the discharging capacity smoothing data is not limited, and unlike described above, defect determination for the discharging capacity smoothing data may be performed first.

As such, the battery management apparatus 1 according to an embodiment may use the voltage smoothing data and the discharging capacity smoothing data obtained by smoothing the raw data, thereby more precisely diagnosing a battery defect.

Meanwhile, disclosed embodiments may be implemented in the form of a recording medium that stores an instruction executable by a computer. The instruction may be stored in the form of a program code, and, when executed by a processor, may generate a program module and perform operations according to disclosed embodiments. The recording medium may be implemented as a computer-readable recording medium.

The computer-readable recording medium may include any type of recording media that store an instruction interpretable by a computer. For example, the computer-readable recording medium may include ROM, RAM, a magnetic tape, a magnetic disk, flash memory, an optical data storage device, etc.

In addition, the computer-readable recording medium may be provided in the form of a non-transitory storage medium. Herein, the term 'non-transitory storage medium' simply means that the storage medium is a tangible device, and does not include a signal (e.g., an electromagnetic wave), but this term does not differentiate between where data is semi-permanently stored in the storage medium and where the data is temporarily stored in the storage medium. For example, the 'non-transitory storage medium' may include a buffer storing data temporarily.

According to an embodiment, a method according to various embodiments disclosed herein may be included and provided in a computer program product. The computer program product may be traded as a product between a seller and a buyer. The computer program product may be distributed in the form of a machine-readable recording medium (e.g., compact disc read only memory (CD-ROM)), or be distributed (e.g., downloaded or uploaded) online via an application store (e.g., PlayStore™), or between two user devices (e.g., smart phones) directly. When distributed online, at least a part of the computer program product (e.g., a downloadable app) may be temporarily generated or at least temporarily stored in the machine-readable recording medium, such as memory of the manufacturer's server, a server of the application store, or the memory 102 of a relay server.

Even though all components constituting an embodiment disclosed herein have been described above as being combined into one or operating in combination, the embodiments disclosed herein are not necessarily limited to the embodiment. That is, within the object scope of the embodiments disclosed herein, all the components may operate by being selectively combined into one or more.

Moreover, terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in this document.

The above description is merely illustrative of the technical idea disclosed herein, and various modifications and variations will be possible without departing from the essential characteristics of the embodiments disclosed herein by those of ordinary skill in the art to which the embodiments disclosed herein pertains. Therefore, the embodiments disclosed herein are intended for description rather than limitation of the technical spirit of the embodiments disclosed herein and the scope of the technical spirit disclosed herein is not limited by these embodiments. The protection scope of the technical spirit disclosed herein should be interpreted by the following claims, and all technical spirits within the same range should be understood to be included in the range of this document.

## Claims

1. A battery management apparatus comprising:

    a communication unit configured to receive battery data comprising voltage data of a battery cell; and
    a control unit configured to generate discharging capacity change rate data based on the battery data, smooth the voltage data and the discharging capacity change rate data to obtain voltage smoothing data and discharging capacity smoothing data, and determine that the battery cell is defective based on that the voltage smoothing data and the discharging capacity smoothing data satisfy a defect determination condition.

2. The battery management apparatus of claim 1, wherein the controller is further configured to perform exponential smoothing on the voltage data and the discharging capacity change rate data based on a smoothing coefficient applied to exponential smoothing.

**3.** The battery management apparatus of claim 2, wherein the controller is further configured to obtain a predicted value by performing weighted averaging on a past predicted value and a past observed value to exponentially smooth the voltage data and the discharging capacity change rate data.

**4.** The battery management apparatus of claim 1, wherein the controller is further configured to determine that the battery cell is defective, based on that the voltage smoothing data and the discharging capacity smoothing data satisfy the defect determination condition at the same time in a preset determination period.

**5.** The battery management apparatus of claim 4, wherein the controller is further configured to determine that the voltage smoothing data and the discharging capacity smoothing data satisfy the defect determination condition, based on that the voltage smoothing data is less than a voltage average of a plurality of battery cells for a preset unit time and the discharging capacity smoothing data is greater than a discharging capacity change rate of the plurality of battery cells for the unit time.

**6.** The battery management apparatus of claim 5, wherein the controller is further configured to determine that the voltage smoothing data and the discharging capacity smoothing data satisfy the defect determination condition, based on that a number of times the voltage smoothing data is less than the voltage average and a number of times the discharging capacity smoothing data exceeds the discharging capacity change rate are greater than or equal to a preset reference number of times in the determination period.

**7.** The battery management apparatus of claim 1, wherein the controller is further configured to transmit information about the battery cell determined as being defective to an external device through the communication unit.

**8.** A battery management method comprising:

receiving battery data comprising voltage data of a battery cell;
generating discharging capacity change rate data based on the battery data;
smoothing the voltage data and the discharging capacity change rate data to obtain voltage smoothing data and discharging capacity smoothing data; and
determining that the battery cell is defective, based on that the voltage smoothing data and the discharging capacity smoothing data satisfy a defect determination condition.

**9.** The battery management method of claim 8, wherein the smoothing of the voltage data and the discharging capacity change rate data comprises performing exponential smoothing on the voltage data and the discharging capacity change rate data based on a smoothing coefficient applied to exponential smoothing.

**10.** The battery management method of claim 9, wherein the smoothing of the voltage data and the discharging capacity change rate data comprises obtaining a predicted value by performing weighted averaging on a past predicted value and a past observed value to exponentially smooth the voltage data and the discharging capacity change rate data.

**11.** The battery management method of claim 8, wherein the determining that the battery cell is defective comprises determining that the battery cell is defective, based on that the voltage smoothing data and the discharging capacity smoothing data satisfy the defect determination condition at the same time in a preset determination period.

**12.** The battery management method of claim 11, further comprising determining that the voltage smoothing data and the discharging capacity smoothing data satisfy the defect determination condition, based on that the voltage smoothing data is less than a voltage average of a plurality of battery cells for a preset unit time and the discharging capacity smoothing data is greater than a discharging capacity change rate of the plurality of battery cells for the unit time.

**13.** The battery management method of claim 12, further comprising determining that the voltage smoothing data and the discharging capacity smoothing data satisfy the defect determination condition, based on that a number of times the voltage smoothing data is less than the voltage average and a number of times the discharging capacity smoothing data exceeds the discharging capacity change rate are greater than or equal to a preset reference number of times in the determination period.

**14.** The battery management method of claim 8, further comprising transmitting information about the battery cell determined as being defective to an external device through a communication unit.

FIG.1

BATTERY MANAGEMENT APPARATUS
1

CONTROL UNIT
100

PROCESSOR
110

MEMORY
120

COMMUNICATION UNIT
200

WIRELESS
COMMUNICATION
UNIT
210

WIRED
COMMUNICATION
UNIT
220

VOLTAGE SENSOR
2

CURRENT SENSOR
3

EXTERNAL DEVICE
4

FIG.2

FIG.3

FIG.4A

FIG.4B

FIG.5A

FIG.5B

| CONDITION | VOLTAGE(V) | DISCHARGING CAPACITY CHANGE RATE(dQ/dV) |
|---|---|---|
| UNIT TIME DETERMINATION CONDITION (a) | -45 | 0.4 |
| MINIMUM DETERMINATION CONDITION (b) | 221 | 151 |
| MAXIMUM DETERMINATION CONDITION (c) | 280 | 220 |
| COUNT DETERMINATION CONDITION (d) | 59 | 65 |

FIG.6

START

RECEIVE BATTERY DATA OF
PLURALITY OF BATTERY CELLS ~700

GENERATE VOLTAGE DATA AND
DISCHARGING CAPACITY CHANGE
RATE DATA BASED ON BATTERY DATA ~710

PERFORM EXPONENTIAL SMOOTHING ON
VOLTAGE DATA AND
DISCHARGING CAPACITY CHANGE RATE DATA ~720

NUMBER OF
TIMES VOLTAGE SMOOTHING
DATA IS LESS THAN VOLTAGE AVERAGE >
REFERENCE NUMBER OF
TIMES? 730

NO

YES

NUMBER OF
TIMES DISCHARGING CAPACITY
SMOOTHING DATA IS LESS THAN DISCHARGING
CAPACITY CHANGE RATE AVERAGE >
REFERENCE NUMBER OF
TIMES? 740

NO

YES

DETERMINE THAT BATTERY CELL IS DEFECTIVE ~750

END

FIG.7

## INTERNATIONAL SEARCH REPORT

| International application No. |
| --- |
| **PCT/KR2024/017330** |

| A. | CLASSIFICATION OF SUBJECT MATTER |
| --- | --- |

**G01R 31/396**(2019.01)i; **G01R 31/382**(2019.01)i; **G01R 31/392**(2019.01)i; **G01R 19/00**(2006.01)i; **G01R 31/371**(2019.01)i; **G01R 31/36**(2006.01)i

According to International Patent Classification (IPC) or to both national classification and IPC

| B. | FIELDS SEARCHED |
| --- | --- |

Minimum documentation searched (classification system followed by classification symbols)

G01R 31/396(2019.01); G01R 19/00(2006.01); G01R 31/3835(2019.01); G01R 31/50(2020.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 관리(management), 평활화(smoothing), 방전용량(discharging capacity), 전압(voltage), 검출(detection)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | KR 10-2022-0019564 A (LG ENERGY SOLUTION, LTD.) 17 February 2022 (2022-02-17) See claims 1 and 13 and figures 1-2. | 1-14 |
| A | KR 10-2019-0141759 A (GUANGDONG OPPO MOBILE TELECOMMUNICATIONS CORP., LTD.) 24 December 2019 (2019-12-24) See claims 1-2 and figures 1-11. | 1-14 |
| A | KR 10-2022-0094469 A (LG ENERGY SOLUTION, LTD.) 06 July 2022 (2022-07-06) See claim 1 and figures 1-5. | 1-14 |
| A | KR 10-2022-0100471 A (LG ENERGY SOLUTION, LTD.) 15 July 2022 (2022-07-15) See claims 1-14 and figures 1-12. | 1-14 |
| A | CN 115792683 A (NINGDE CONTEMPORARY AMPEREX TECHNOLOGY CO., LTD.) 14 March 2023 (2023-03-14) See claims 1-12 and figures 1-4. | 1-14 |

☐ Further documents are listed in the continuation of Box C. ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **14 February 2025** | **14 February 2025** |

| Name and mailing address of the ISA/KR | Authorized officer |
| --- | --- |
| **Korean Intellectual Property Office** **Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2024/017330**

| Patent document cited in search report | | | Publication date (day/month/year) | Patent family member(s) | | | Publication date (day/month/year) |
|---|---|---|---|---|---|---|---|
| KR | 10-2022-0019564 | A | 17 February 2022 | CN | 115552262 | A | 30 December 2022 |
| | | | | EP | 4134686 | A1 | 15 February 2023 |
| | | | | EP | 4134686 | A4 | 04 October 2023 |
| | | | | JP | 2023-524846 | A | 13 June 2023 |
| | | | | JP | 7501976 | B2 | 18 June 2024 |
| | | | | US | 12130338 | B2 | 29 October 2024 |
| | | | | US | 2023-0194622 | A1 | 22 June 2023 |
| | | | | WO | 2022-035151 | A1 | 17 February 2022 |
| KR | 10-2019-0141759 | A | 24 December 2019 | CN | 109716579 | A | 03 May 2019 |
| | | | | CN | 109716579 | B | 01 February 2022 |
| | | | | EP | 3657591 | A1 | 27 May 2020 |
| | | | | EP | 3657591 | A4 | 03 June 2020 |
| | | | | EP | 3657591 | B1 | 14 July 2021 |
| | | | | JP | 2020-523968 | A | 06 August 2020 |
| | | | | JP | 6938687 | B2 | 22 September 2021 |
| | | | | KR | 10-2301102 | B1 | 10 September 2021 |
| | | | | US | 11522357 | B2 | 06 December 2022 |
| | | | | US | 2020-0099216 | A1 | 26 March 2020 |
| | | | | WO | 2019-037113 | A1 | 28 February 2019 |
| KR | 10-2022-0094469 | A | 06 July 2022 | CN | 115803645 | A | 14 March 2023 |
| | | | | EP | 4180826 | A1 | 17 May 2023 |
| | | | | EP | 4180826 | A4 | 13 March 2024 |
| | | | | JP | 2023-528403 | A | 04 July 2023 |
| | | | | JP | 2024-099625 | A | 25 July 2024 |
| | | | | JP | 7477257 | B2 | 01 May 2024 |
| | | | | US | 2023-0314514 | A1 | 05 October 2023 |
| | | | | WO | 2022-145831 | A1 | 07 July 2022 |
| KR | 10-2022-0100471 | A | 15 July 2022 | CN | 116724244 | A | 08 September 2023 |
| | | | | EP | 4276483 | A1 | 15 November 2023 |
| | | | | EP | 4276483 | A4 | 26 June 2024 |
| | | | | JP | 2024-501304 | A | 11 January 2024 |
| | | | | US | 2024-0003980 | A1 | 04 January 2024 |
| | | | | WO | 2022-149917 | A1 | 14 July 2022 |
| CN | 115792683 | A | 14 March 2023 | None | | | |

Form PCT/ISA/210 (patent family annex) (July 2022)